# EUROPEAN PATENT SPECIFICATION

(11) **EP 2 267 536 B1**
(45) Date of publication and mention of the grant of the patent: **19.04.2017**
(21) Application number: 10180248.6
(22) Date of filing: 26.10.2004
(51) Int. Cl.: G03F 7/20

(54) **Lithographic apparatus**
Lithographischer Apparat
Appareil lithographique

(30) Priority: 28.10.2003 EP 03256820
(43) Date of publication of application: 29.12.2010
(62) Divisional of application: 04256585.3
(73) Proprietor: ASML Netherlands B.V., 5504 DR Veldhoven (NL)
(72) Inventor: Hoogendam, Christiaan, 5563 AR, Westerhoven (NL); Bijlaart, Erik, 5247 XM, Rosmalen (NL); Kolesnychenko, Aleksey, 5701 EE, Helmond (NL); Loopstra, Erik, NL-5613 ES, Eindhoven (NL); Mertens, Jeroen, 5511 AM Knegsel (NL); Mulkens, Johannes, 5552 MA, Valkenswaard (NL); Slaghekke, Bernardus, 5502 PB, Veldhoven (NL); Streefkerk, Bob, 5038 PE, Tilburg (NL); Tinnemans, Patricius, 5527GR, Hapert (NL); Van Santen, Helmar, 1018 BB, Amsterdam (NL)
(74) Representative: Corcoran, Gregory Martin Mason

(56) References cited:
- EP-A- 0 605 103
- EP-A- 0 834 773
- EP-A- 1 420 302
- EP-A- 1 482 372
- EP-A- 1 494 079
- WO-A-99/49504
- WO-A-2004/055803
- WO-A-2005/015315
- JP-A- 63 157 419
- JP-A- 2003 297 735

## Description

### Field

The present invention relates to a lithographic apparatus.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

It has been proposed to immerse the substrate in the lithographic projection apparatus in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system and also increasing the depth of focus.) Other immersion liquids have been proposed, including water with solid particles (e.g. quartz) suspended therein.

However, submersing the substrate or substrate and substrate table in a bath of liquid (see for example US 4,509,852 ) means that there is a large body of liquid that must be accelerated during a scanning exposure. This requires additional or more powerful motors and turbulence in the liquid may lead to undesirable and unpredictable effects.

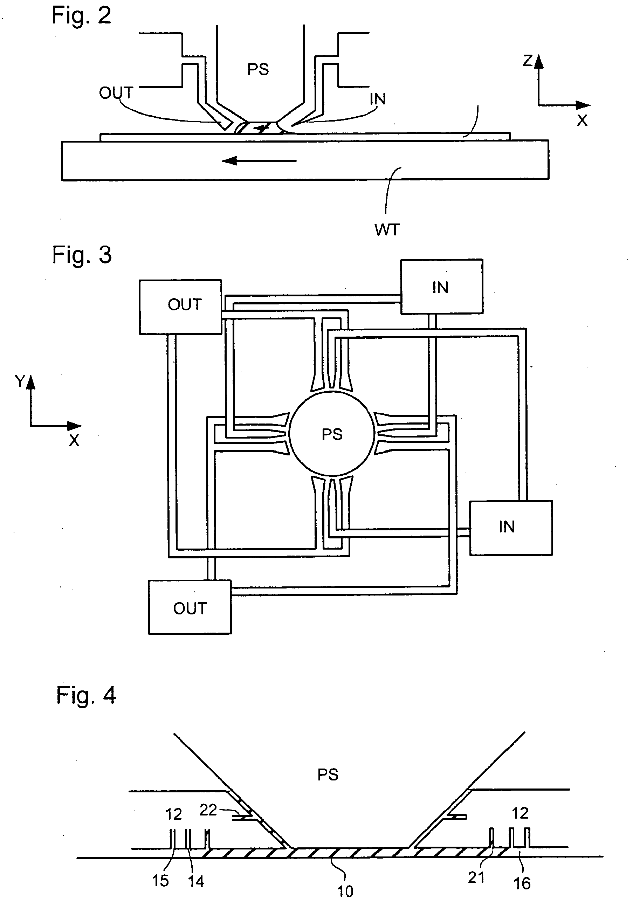

One of the solutions proposed is for a liquid supply system to provide liquid on only a localized area of the substrate and in between the final element of the projection system and the substrate using a liquid confinement system (the substrate generally has a larger surface area than the final element of the projection system). One way which has been proposed to arrange for this is disclosed in WO 99/49504. As illustrated in Figures 2 and 3, liquid is supplied by at least one inlet IN onto the substrate, preferably along the direction of movement of the substrate relative to the final element, and is removed by at least one outlet OUT after having passed under the projection system. That is, as the substrate is scanned beneath the element in a - X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the substrate relative to the final element, though this does not need to be the case. Various orientations and numbers of in- and out-lets positioned around the final element are possible, one example is illustrated in Figure 3 in which four sets of an inlet with an outlet on either side are provided in a regular pattern around the final element.

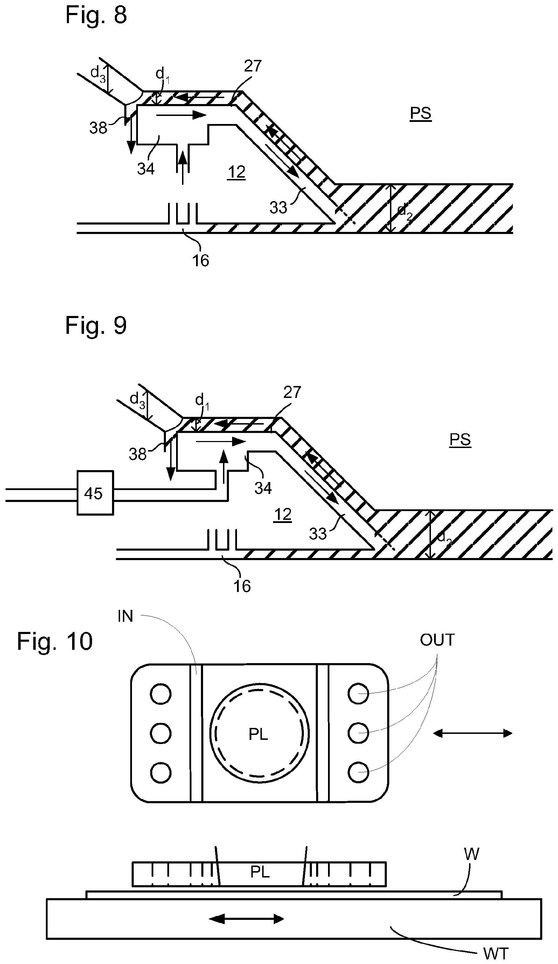

Another solution which has been proposed is to provide the liquid supply system with a seal member which extends along at least a part of a boundary of the space between the final element of the projection system and the substrate table. Such a solution is illustrated in Figure 10. The seal member is substantially stationary relative to the projection system in the XY plane though there may be some relative movement in the Z direction (in the direction of the optical axis). A seal is formed between the seal member and the surface of the substrate. Preferably the seal is a contactless seal such as a gas seal. Such as system with a gas seal is disclosed in European Patent Application No. 03252955.4

In European Patent Application No. 03257072.3 the idea of a twin or dual stage immersion lithography apparatus is disclosed. Such an apparatus is provided with two stages for supporting the substrate. Leveling measurements are carried out with a stage at a first position, without immersion liquid, and exposure is carried out with a stage at a second position, where immersion liquid is present. Alternatively, the apparatus has only one stage.

However, if the liquid remains stationary, temperature fluctuations can cause wave front disturbances in the projection beam and thus cause errors in the projected image. It has therefore been proposed to refresh the liquid periodically. However, using the seal described above, or an outlet in the vicinity of the seal to remove the liquid causes mechanical vibrations thereby disturbing the exposure. Also, the pressure involved in liquid refreshment is high and the projection system is highly sensitive to pressure variations which can cause deformations in the final element of the projection system and disturbances. Consequently the depth of liquid around the projection system should be kept constant.

The motion of the substrate relative to the projection system can generate a pressure gradient. In some circumstances this can lead to the liquid being swept from underneath the projection system. Unless the liquid is uniform under the projection system, or if gas bubbles are present under the projection system the accuracy of the exposure will be compromised.

If an error occurs in the apparatus such as failure of the seal or the substrate table is accidentally removed from beneath the projection system the liquid will be dispersed throughout the apparatus potentially damaging the apparatus unless the liquid is removed quickly. The liquid supply systems proposed above, particularly the one including the gas seal do not provide a fast enough way of evacuating the liquid.

It is an object of the present invention to provide a system in which pressure fluctuations and/or temperature variations in the liquid are minimized without introducing unnecessary disturbances due to mechanical vibrations.

These and other objects are achieved according to the invention in a lithographic apparatus as defined in the appended claims.

The fluid directly under the projection system is therefore refreshed. The fluid flows from the inlet to the area directly under the projection system where it circulates before being removed via an outlet. This is further aided by the liquid supply system being arranged such that a passage is formed between an element of the projection system and said seal member for the flow of liquid towards an outlet. The flow of fluid towards the outlet is thus confined. The outlet can be arranged at the end of the passage. The liquid thus has a minimal free surface such that there are no surface waves and the static hydraulic pressures area minimized. Immersion fluid is supplied to the inlet through a chamber. The chamber is arranged to create only a small pressure drop between the chamber and the inlet. For example the chamber should have a greater cross-sectional area than the cross-sectional area of the inlet.

In the present document, the terms "radiation" and "beam" are used to encompass all types of electromagnetic radiation, including ultraviolet radiation (e.g. with a wavelength of 365, 248, 193, 157 or 126 nm).

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus according to an embodiment of the invention;
Figures 2 and 3 depict a liquid supply system used in a prior art lithographic projection apparatus;
Figure 4 is a detail of a lithographic projection apparatus according to an example;
Figure 5 is a detail of a lithographic projection apparatus according to an example showing an overflow;
Figure 6 is a detail of an alternative lithographic projection apparatus according to an embodiment of the invention;
Figure 7 is a detail of an alternative lithographic projection apparatus according to an embodiment of the invention;
Figure 8 is a detail of an alternative lithographic projection apparatus according to an embodiment of the invention;
Figure 9 is a detail of an embodiment of the invention; and
Figure 10 depicts a liquid supply system according to another prior art lithographic projection apparatus.

In the Figures, corresponding reference symbols indicate corresponding parts.

### DETAILED DESCRIPTION

### Example 1

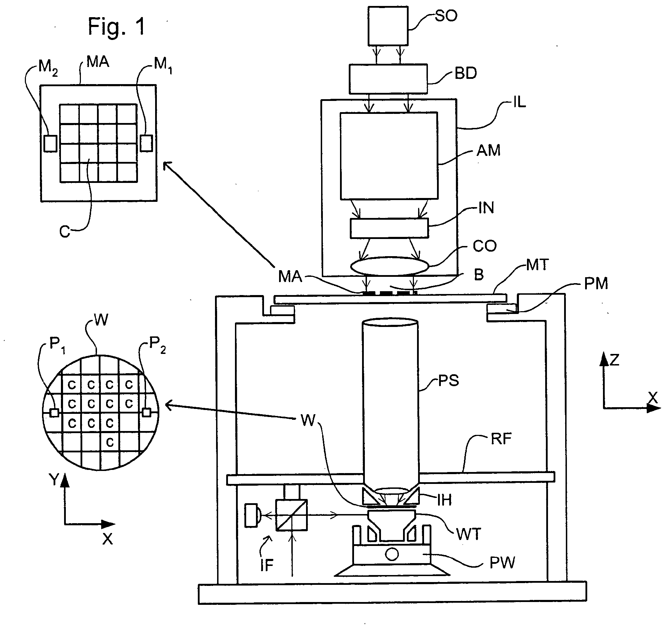

Figure 1 schematically depicts a lithographic apparatus according to, an example. The apparatus comprises:
- an illumination system (illuminator) IL configured to condition a radiation beam B (e.g. UV radiation or DUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

As shown in Figure 4 a liquid reservoir 10 between the projection lens and the substrate is bounded by a gas seal 16 forming an annulus around the projection lens. The seal, preferably a gas seal is formed by gas, e.g. air or synthetic air but preferably N₂ or another inert gas, provided under pressure via inlet 15 to the gap between seal member 12 and substrate and extracted via first outlet 14. The overpressure on the gas inlet 15, vacuum level on the first outlet 14 and geometry of the gap are arranged so that there is a high-velocity air flow inwards that confines the liquid. The distance between the gas inlet and outlet and the substrate W is small.

The liquid reservoir is supplied with liquid by inlets 21 and 22 and excess liquid is removed via outlet 14. The liquid reservoir extends above the bottom of the final element of the projection system PS to the level where the seal member 12 bounding the liquid reservoir and forming a barrier suddenly widens as shown in Figure 4. The top of the seal member forms a ridge, the area of which is of an area similar to or larger than the area of the bottom of the final element of the projection system PL. Therefore, if the quantity of liquid in the reservoir increases dramatically the depth of the reservoir 10 will not increase significantly as a large increase in the volume of immersion liquid over the large area of the top of the seal member 12 will not generate a large change in the depth of immersion fluid. The pressure variations due to a change in the depth of the reservoir will therefore be minimal.

### Example 2

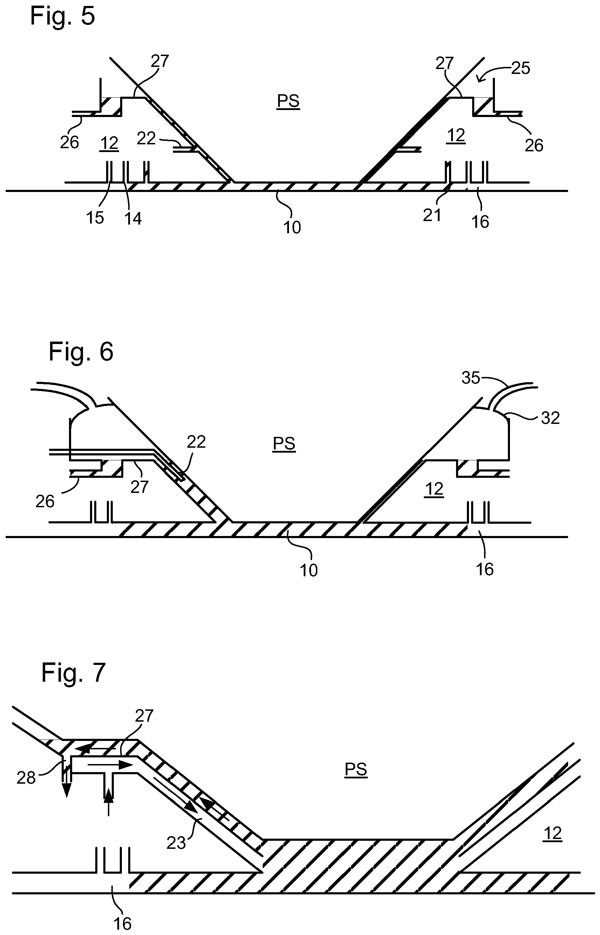

Figure 5 shows an alternative arrangement for the structure described in embodiment 1. An overflow structure 25 collects any excess liquid. The increase in depth of the liquid reservoir 10 due to an increase in the quantity of liquid is likely to be very small as a large amount of excess liquid can be accommodated in overflow structure 25. There is an annular shaped dyke 27 forming a barrier bounding the fluid and as the amount of liquid increases it flows over dyke 27 and into channel 26 which is an outlet, removing liquid from the reservoir 10. In this example the majority of the liquid is removed via channel 26 rather than outlet 14. The depth of fluid is thus controlled by the height of the dyke 27. As large amounts of liquid are not being removed via outlet 14 fewer vibrations are induced in the seal member 12 and the gas seal 16 functions more effectively. The flow rate of channel 26 should be sufficiently low to ensure that the gas content is small. Channel 26 is arranged above inlets 21 and 22 so the fluid overflows into channel 26.

### Embodiment 3

The embodiment shown in Figure 6 is the same as the embodiments above except for the aspects described below. There is just one inlet 22, separate from the seal member 12. Inlet 22 is formed between the projection system PS and the seal member 12 and fluid flows out from the inlet 22 at a height below that of the dyke 27, but above that of the bottom of the final element of the projection system PS. Fluid is supplied at a constant rate R, but, similarly to embodiment 3, the fluid is predominantly removed via channel 26 rather than gas outlet 14. The rate of substance removal through channel 26 is also a constant rate R. Seal 32 confines the gas around the reservoir 10 and prevents the moisture laden gas from pervading the whole apparatus, thereby damaging delicate parts and compromising the accuracy of measurements, e.g. interferometer readings. To keep the gas pressure above the reservoir 10 constant, and therefore the pressure at the final element of the projection system PS constant there is a passage 34 through the seal 32 through which gas can flow. The passage 34 leads outside the apparatus, thereby removing moisture laden air. The passage 34 should preferably have a low resistance allowing the gas to flow freely.

### Embodiment 4

In this embodiment fluid is supplied through concentric ring (i.e. annular) shaped inlet 23 arranged on the inner circumference of seal member 12 shown in Figure 7. Inlet 23 has a slit width of approximately 20 µm to 300 µm, preferably 150µm, is arranged at a distance of approximately 0.5mm from the substrate W and directs a channel of fluid towards the area directly under the projection system PS (i.e. the target portion) such that the fluid directly under the projection system PS is constantly refreshed. In this example the inlet 23 forms the inner edge of the seal member 12, but it could also be arranged so it was just adjacent to the inner circumference of the seal member 12. Alternatively inlet 23 could be a plurality of pipes arranged on the inner circumference of the seal member 12. As shown in Figure 7 a passage is formed between elements of the projection system PS and the seal member 12. Having circulated under the final element of the projection system PS the fluid flows through this passage and over the dyke 27 prior to being removed via outlet 28. However, unlike the earlier embodiments elements of the projection system PS, or another part of the apparatus bounds the upper level of the reservoir 10. No surface waves can therefore occur and static hydraulic pressures are limited resulting in a continuous uniform pressure on the projection system PS.

### Embodiment 5

The embodiment is the same as embodiment 4 except for the aspects described below. Inlet 33 is annular shaped with a diameter of approximately 50-100mm and a width of 20µm to 300µm, preferably 150µm. As shown in Figure 8 the inlet 33 can end before the bottom of the seal member 12 or can extend to the bottom of the seal member 12 or anywhere in between. Immersion liquid is supplied to inlet 33 through chamber 34 which has a greater cross-sectional area than inlet 33 to ensure that the chamber 34 provides a smaller restriction to flow.

In this embodiment the seal member 12 and the projection system PS are arranged such that the immersion fluid is held between the seal member 12 and the projection system PL by capillary forces at the level of dyke 27.

The edges of seal member 12 slope towards the projection system PS with an angle to the direction of propagation of the radiation beam B of approximately 45°. Dyke 27 intersects this slope and forms a broad ridge substantially perpendicular to the direction of propagation of the radiation beam B. The edges of projection system PS form a complimentary shape to the seal member 12 having a slope to the direction of propagation of the projection beam B of approximately 45° and also having a broad area perpendicular to the direction of propagation of the radiation beam B radially outwardly of the slope.

Outlet 38 is arranged beyond dyke 27 and has a greater flow rate than the rate of flow through inlet 33 to make sure that the amount of immersion fluid in reservoir 10 is controlled. Consequently some gas is also removed through outlet 38. Distance d₃ is governed by the actuation height of the seal member 12 and in this example is at least 2 mm. Distance d₃ should however be as large as possible to ensure that there is sufficient air flow for outlet 38. This arrangement of apparatus ensures that the depth of immersion fluid remains constant at the level of the projection system PS just above dyke 27.

To prevent the final element of the projection system PS from damage the distance d₁ between dyke 27 and the projection system PS is 2mm whereas the distance d₂ between the final element of the projection system PS and the substrate is greater than 2mm.

### Embodiment 6

In this embodiment the flow of fluid through the inlet 33 is controlled by valve 45 shown in Figure 9. During ordinary operation of the apparatus valve 45 allows fluid to flow freely through inlet 33. However, when an error is detected in the system or apparatus, for example accidental removal of the substrate W and substrate table WT or a servo error, valve 45 automatically connects inlet 33 to a high vacuum chamber (not shown in the accompanying drawings). The liquid can therefore be quickly removed from the reservoir. The valve 45 and associated vacuum chamber can be connected to other inlets e.g. inlets 21 and 23 shown in embodiments 4 to 7.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "reticle", "wafer" or "die" herein may be considered as synonymous with the more general terms "mask", "substrate" or "target portion", respectively. The substrate referred to herein may be processed, before or after exposure, in for example a track (a tool that typically applies a layer of resist to a substrate and develops the exposed resist) a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The present invention can be applied to any immersion lithography apparatus, in particular, but not exclusively, those types mentioned above.

The descriptions above are intended to be illustrative, not limiting. Thus, it will be apparent to one skilled in the art that modifications may be made to the invention as described without departing from the scope of the claims set out below.

## Claims

1. A lithographic apparatus comprising:
a substrate table (WT) for holding a substrate (W);
a projection system (PS) for projecting a radiation beam (B) having a patterned cross-section onto a target portion (C) of the substrate (W); and
a liquid supply system for at least partly filling a space between the projection system (PS) and the substrate (W) with a liquid to form a liquid reservoir (10), said liquid supply system comprising:
an inlet (22, 23, 33) for supplying liquid to the space; and
a seal member (12) extending along at least a part of the boundary of the space between the projection system (PS) and the substrate table (WT),
**characterized in that** the inlet (22, 23, 33) is adjacent to the inner circumference of the seal member (12) and is directed towards the target portion (C) of the substrate (W),
and **in that**
the lithographic apparatus further comprising a chamber (34) through which the liquid is supplied to the inlet (22, 23, 33), the chamber (34) having a larger cross-sectional area than the cross-sectional area of the inlet (22, 23, 33).

2. The lithographic apparatus according to claim 1, wherein the inlet (23, 33) has an annular shape and is arranged on the inner circumference of the seal member (12).

3. The lithographic apparatus according to claim 1, wherein the inlet (23) comprises a plurality of pipes arranged on the inner circumference of the seal member (12).

4. The lithographic apparatus according to claim 1, wherein the inlet (22) is separate from the seal member (12).

5. The lithographic apparatus according to any of the preceding claims, wherein the liquid supply system is arranged such that a passage is formed between an element of the projection system (PS) and the seal member (12) for a flow of liquid towards an outlet (28, 38).

6. The lithographic apparatus according to claim 5, wherein the outlet (28, 38) is at the end of the passage.

7. The lithographic apparatus according to any of claims 1 to 4, further comprising an outlet (38) for removing liquid from the space, the seal member (12) and the projection system (PS) forming a capillary passage, the outlet (38) being arranged to remove the liquid at the end of at least part of said capillary passage.

8. The lithographic apparatus according to claim 7, wherein the outlet (38) removes gas in addition to the liquid.

9. The lithographic apparatus according to any of the preceding claims, wherein the inlet (23, 33) is controlled by a valve (45) connected to a high vacuum source.

10. The lithographic apparatus according to claim 9, wherein the valve (45) automatically connects the inlet (23, 33) to the high vacuum source upon a system failure.

## Patentansprüche

1. Ein lithographisches Gerät, das Folgendes beinhaltet:
einen Substrattisch (WT) zum Halten eines Substrats (W);
ein Projektionssystem (PS) zum Projizieren eines Strahlungsstrahls (B) mit einem gemusterten Querschnitt auf einen Zielabschnitt (C) des Substrats (W); und
ein Flüssigkeitszufuhrsystem, um einen Raum zwischen dem Projektionssystem (PS) und
dem Substrat (W) mindestens teilweise mit einer Flüssigkeit zu füllen, um ein Flüssigkeitsreservoir (10) zu bilden, wobei das Flüssigkeitszufuhrsystem Folgendes beinhaltet:
einen Einlass (22, 23, 33), um dem Raum Flüssigkeit zuzuführen; und
ein Dichtungsglied (12), das sich entlang mindestens eines Teils der Grenze des
Raums zwischen dem Projektionssystem (PS) und dem Substrattisch (WT) erstreckt, **dadurch gekennzeichnet, dass** der Einlass (22, 23, 33) neben dem inneren Umfang des Dichtungsglieds (12) liegt und in Richtung des Zielabschnitts (C) des Substrats (W) gerichtet ist,
und dass
das lithographische Gerät ferner eine Kammer (34) beinhaltet, durch die die Flüssigkeit dem Einlass (22, 23, 33) zugeführt wird, wobei die Kammer (34) einen größeren Querschnittsbereich als der Querschnittsbereich des Einlasses (22, 23, 33) aufweist.

2. Lithographisches Gerät gemäß Anspruch 1, wobei der Einlass (23, 33) eine ringförmige Form aufweist und auf dem inneren Umfang des Dichtungsglieds (12) angeordnet ist.

3. Lithographisches Gerät gemäß Anspruch 1, wobei der Einlass (23) eine Vielzahl von Leitungen beinhaltet, die auf dem inneren Umfang des Dichtungsglieds (12) angeordnet sind.

4. Lithographisches Gerät gemäß Anspruch 1, wobei der Einlass (22) separat von dem Dichtungsglied (12) ist.

5. Lithographisches Gerät gemäß einem der vorhergehenden Ansprüche, wobei das Flüssigkeitszufuhrsystem derart angeordnet ist, dass zwischen einem Element des Projektionssystems (PS) und dem Dichtungsglied (12) ein Durchgang für einen Durchfluss von Flüssigkeit in Richtung eines Auslasses (28, 38) gebildet ist.

6. Lithographisches Gerät gemäß Anspruch 5, wobei sich der Auslass (28, 38) an dem Ende des Durchgangs befindet.

7. Lithographisches Gerät gemäß einem der Ansprüche 1 bis 4, das ferner einen Auslass (38) zum Entfernen von Flüssigkeit aus dem Raum beinhaltet, wobei das Dichtungsglied (12) und das Projektionssystem (PS) einen Kapillardurchgang bilden und der Auslass (38) angeordnet ist, um die Flüssigkeit an dem Ende mindestens eines Teils des Kapillardurchgangs zu entfernen.

8. Lithographisches Gerät gemäß Anspruch 7, wobei der Auslass (38) zusätzlich zu der Flüssigkeit Gas entfernt.

9. Lithographisches Gerät gemäß einem der vorhergehenden Ansprüche, wobei der Einlass (23, 33) durch ein mit einer Hochvakuumquelle verbundenes Ventil (45) gesteuert wird.

10. Lithographisches Gerät gemäß Anspruch 9, wobei das Ventil (45) den Einlass (23, 33) bei einem Systemversagen automatisch mit der Hochvakuumquelle verbindet.

## Revendications

1. Un appareil lithographique comprenant :
une table porte-substrat (WT) destinée à porter un substrat (W) ;
un système de projection (PS) destiné à projeter un faisceau de rayonnement (B) présentant une coupe transversale à motif sur une portion cible (C) du substrat (W) ; et
un système d'amenée de liquide destiné à remplir au moins partiellement un espace entre le système de projection (PS) et le substrat (W) avec un liquide afin de former un réservoir de liquide (10), ledit système d'amenée de liquide comprenant :
une admission (22, 23, 33) destinée à amener du liquide jusqu'à l'espace ; et
un élément d'étanchéité (12) s'étendant le long d'au moins une partie de la délimitation de l'espace entre le système de projection (PS) et la table porte-substrat (WT),
**caractérisé en ce que** l'admission (22, 23, 33) est adjacente à la circonférence interne de l'élément d'étanchéité (12) et est dirigée vers la portion cible (C) du substrat (W),
et **en ce que**
l'appareil lithographique comprend en sus une chambre (34) au travers de laquelle le liquide est amené jusqu'à l'admission (22, 23, 33), la chambre (34) présentant une superficie en coupe transversale plus grande que la superficie en coupe transversale de l'admission (22, 23, 33).

2. L'appareil lithographique selon la revendication 1, dans lequel l'admission (23, 33) présente une forme annulaire et est agencée sur la circonférence interne de l'élément d'étanchéité (12).

3. L'appareil lithographique selon la revendication 1, dans lequel l'admission (23) comprend une pluralité de tuyaux agencés sur la circonférence interne de l'élément d'étanchéité (12).

4. L'appareil lithographique selon la revendication 1, dans lequel l'admission (22) est distincte de l'élément d'étanchéité (12).

5. L'appareil lithographique selon n'importe lesquelles des revendications précédentes, dans lequel le système d'amenée de liquide est agencé de telle sorte qu'un passage soit formé entre un élément du système de projection (PS) et l'élément d'étanchéité (12) pour un écoulement de liquide vers une sortie (28, 38).

6. L'appareil lithographique selon la revendication 5, dans lequel la sortie (28, 38) se situe à l'extrémité du passage.

7. L'appareil lithographique selon n'importe lesquelles des revendications 1 à 4, comprenant en sus une sortie (38) destinée à retirer du liquide de l'espace, l'élément d'étanchéité (12) et le système de projection (PS) formant un passage capillaire, la sortie (38) étant agencée afin de retirer le liquide à l'extrémité d'au moins une partie dudit passage capillaire.

8. L'appareil lithographique selon la revendication 7, dans lequel la sortie (38) retire du gaz en plus du liquide.

9. L'appareil lithographique selon n'importe lesquelles des revendications précédentes, dans lequel l'admission (23, 33) est contrôlée par une valve (45) raccordée à une source de vide poussé.

10. L'appareil lithographique selon la revendication 9, dans lequel la valve (45) raccorde automatiquement l'admission (23, 33) à la source de vide poussé lors d'une défaillance du système.
